**Europäisches Patentamt**

**European Patent Office**

**Office européen des brevets**

(19)

(11) Veröffentlichungsnummer: **0 683 566 A1**

# (12) EUROPÄISCHE PATENTANMELDUNG

(21) Anmeldenummer: **95106996.2**

(22) Anmeldetag: **09.05.95**

(51) Int. Cl.⁶: **H03K 23/66**

(30) Priorität: **17.05.94 DE 4417147**

(43) Veröffentlichungstag der Anmeldung:
**22.11.95 Patentblatt 95/47**

(84) Benannte Vertragsstaaten:
**DE FR GB IT**

(71) Anmelder: **SIEMENS AKTIENGESELLSCHAFT**
**Wittelsbacherplatz 2**
**D-80333 München (DE)**

(72) Erfinder: **Heinen, Stefan, Dr.**

**Zur Eibe 9**
**D-47802 Krefeld (DE)**
Erfinder: **Herrmann, Helmut, Dipl.-Ing.**
**Preysingstr. 11**
**D-81667 München (DE)**
Erfinder: **Scheckel, Bruno, Dipl.-Ing.**
**Von Feurystr. 5**
**D-85560 Ebersberg (DE)**
Erfinder: **Wilwert, Jean, Dipl.-Ing.**
**Occamstrasse 5**
**D-80802 München (DE)**

(54) **Schaltungsanordnung zum Teilen eines Taktsignals.**

(57) Die Erfindung betrifft eine Schaltungsanordnung zum Teilen eines Taktsignals mit umschaltbaren Teilerverhältnissen 4/5 in ECL-Technik, mit drei in Reihe geschalteten Flip-Flops (2, 4), wobei der positive Ausgang ($Q_2$, $Q_4$) eines Flip-Flops (2, 4) jeweils mit dem Dateneingang ($D_4$, $D_5$) des nachfolgenden Flip-Flops (4, 5) gekoppelt ist und die Takteingänge ($C_2$; $C_4$; $C_5$) der Flip-Flops (2, 4, 5) mit dem Taktsignal (8, 9) beaufschlagt werden, wobei ein erstes UND-Gatter (3) vorgesehen ist, das zwischen ersten und zweiten Flip-Flop (2, 4) geschaltet, wobei dessen Ausgang ($Q_3$) mit dem Dateneingang ($D_4$) des zweiten Flip-Flops (4) verbunden ist und dessen erster Eingang ($A_3$) mit dem invertierten Ausgang ($\overline{Q_2}$) eines dritten Flip-Flops (2) verbunden ist und dessen zweiter Eingang ($B_3$) mit dem invertierten Ausgangssignal ($\overline{Q_5}$) des ersten Flip-Flops (5) beaufschlagt wird. Dem ersten Flip-Flop (2) ist ein UND-Gatter (1) vorgeschaltet, dessen erster Eingang ($A_1$) mit einem Steuersignal zur Umschaltung des Teilerverhältnisses und dessen zweiter Eingang ($B_1$) mit dem invertierten Ausgangssignal ($\overline{Q_5}$) des dritten Flip-Flops (5) beaufschlagt wird und wobei die gesamte Schaltungsanordnung in differentieller Technik ausgeführt ist.

FIG 1

Die Erfindung betrifft eine Schaltungsanordnung zum Teilen eines Taktsignals gemäß dem Oberbegriff des Anspruchs 1.

Bei der Entwicklung von Mobiltelefon bzw. schnurlosen Telefon wird heute eine Versorgungsspannung von 2,7 Volt angestrebt. Daher ist es notwendig bipolare Vorteiler mit geringer Stromaufnahme für diese Versorgungsspannung zur Verfügung zu stellen. Insbesondere die Realisierung eines benötigten schnellen synchronen 4/5-Teilers führt dabei zu Problemen.

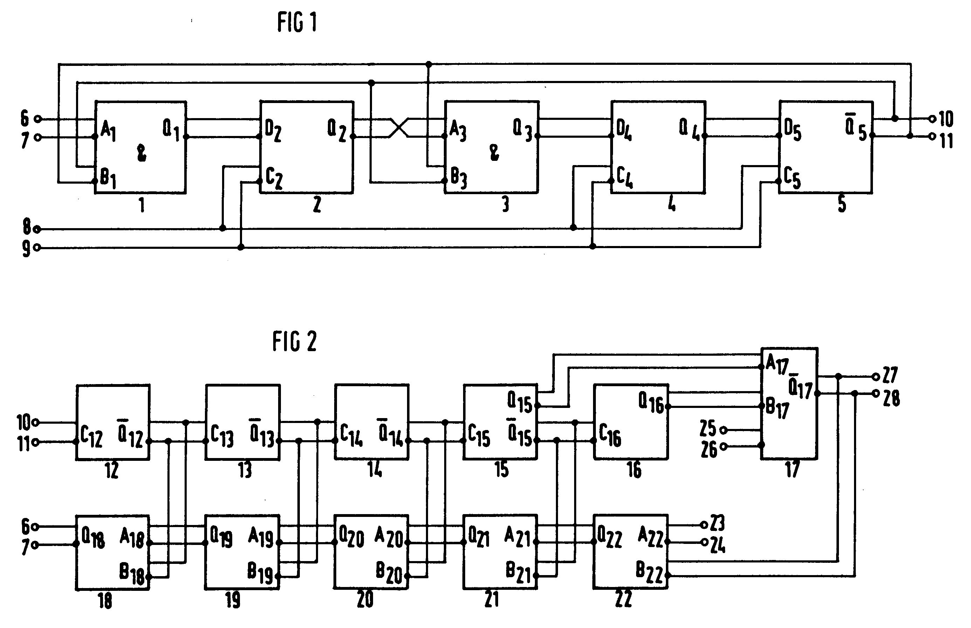

Eine derartige Teilerschaltungsanordnung ist z.B. aus "SP8000 Series High Speed Dividers Integrated Circuit Handbook" von Plessey Semiconductors auf Seite 113ff bekannt. Der darin beschriebene Teilerbaustein SP8690A&B ist in ECL-Technik ausgeführt und benötigt eine Versorgungsspannung von 5 Volt. Der Teiler ist durch einen dreistufigen Johnson-Zähler gemäß der Figur 2 des obengenannten Dokuments realisiert. Für die 2,7 Volt ECL-Schaltungstechnik lassen sich die Gatter nicht mehr derart realisieren, daß ihre Laufzeit eliminiert wird, d.h. die Gatterlaufzeiten der den Flip-Flops vorgeschalteten Gatter addieren sich und führen zu einer Reduzierung der oberen Grenzfrequenz.

Aufgabe der vorliegenden Erfindung ist es daher, eine Schaltungsanordnung in ECL-Technik anzugeben, die es ermöglicht, eine Teilerschaltungsanordnung mit hoher Grenzfrequenz und niedriger Versorgungsspannung vorzusehen.

Diese Aufgabe wird durch den kennzeichnenden Teil des Anspruchs 1 gelöst. Weiterbildungen sind Kennzeichen der Unteransprüche.

Die Erfindung wird nachfolgend anhand von zwei Figuren näher erläutert. Es zeigen

Figur 1     ein Prinzipschaltbild eines 4/5-Teilers,

Figur 2     eine Erweiterungsschaltung für den in Figur 1 dargestellten 4/5-Teiler zu einem $2^n/2^n+1$-Teiler.

In Figur 1 ist mit 1 ein erstes UND-Gatter bezeichnet, dessen erster differentieller Eingangssanschluß $A_1$ mit Anschlußklemmen 6, 7 verbunden sind. Diesen Anschlußklemmen ist ein differentielles Steuersignal zuführbar. Der Ausgang Q1 des UND-Gatters 1 ist ebenso diffentiell ausgeführt und mit einem differenziellen Eingang $D_2$ eines ersten Flip-Flops 2 verbunden. Der Ausgang $Q_2$ des Flip-Flops ist verpolt mit einem ersten Eingang $A_3$ eines zweiten UND-Gatters 3 verbunden, so daß dem UND-Gatter 3 das invertierte Ausgangssignal des Flip-Flops 2 zugeführt wird. Der zweite differentielle Eingang $B_3$ ist invertiert mit dem zweiten differentiellen Eingang $B_1$ des ersten UND-Gatters 1 verbunden. Der differentielle Ausgang $Q_3$ des UND-Gatters 3 ist mit dem differentiellen Eingang $D_4$ eines zweiten Flip-Flops 4 verschaltet. Dessen Ausgang $Q_4$ ist wiederum mit dem differentiellen Eingang $D_5$ eines dritten Flip-Flops 5 verschaltet. Der invertierte Ausgang $\overline{Q}_5$ ist zum einen mit Ausgangsklemmen 10, 11 und zum anderen mit den jeweils zweiten Eingängen $B_1$, $B_3$ der beiden UND-Gatter 1, 3 verschaltet. Den Takteingängen $C_2$, $C_4$, $C_5$ der drei Flip-Flops 2, 4, 5 wird jeweils ein über Anschlußklemmen 8, 9 zuführbares Taktsignal zugeführt.

Eine erfindungsgemäße Anordnung gemäß Figur 1 zeigt einen in der Laufzeit optimierten 4/5-Teiler. Die gezeigte Schaltung des 4/5-Teilers bietet den Vorteil, daß im Vierer-Teilermodus, d.h. bei einem logischen "0"-Signal am Steuereingang 6, 7 das rückgekoppelte D-Flip-Flop 2 seinen Zustand nicht ändert und somit die obere Grenzfrequenz nur durch die Eigenschaften der Blöcke 3, 4, 5 bestimmt wird. Durch Anlegen einer logischen "1" an den differentiellen Steuereingang 6, 7 wird die gesamte Anordnung in den sogenannten Fünfer-Teilermodus geschaltet, in welchem die Laufzeiten der Gatter 1 und 3 durch das Flip-Flop 2 entkoppelt sind und somit führt diese Schaltungsstruktur zu einer höheren Grenzfrequenz bei gleicher Stromaufnahme. Darüber hinaus ermöglicht diese Anordnung ein kompaktes Layout mit geringen parasitären Einflüssen, da nur ein differentielles Signal von einem niederohmigen Ausgang, z.B. einem Emitterfolger, vom Flip-Flop 5 auf die beiden UND-Gatter 1, 3 zurückgekoppelt wird.

Gegenüber den bisher bekannten Schaltungen, welche mit nicht differentiellen Signalen arbeiten, ist die erfindungsgemäße Schaltung vollständig in einer differentiellen ECL-Schaltungstechnik für 2,7 Volt Versorgungsspannung realisiert worden, wobei nur ein differentielles Signal von einem niederohmigen Ausgang rückgekoppelt wird und die Laufzeit der benötigten Gatter durch ein Flip-Flop entkoppelt wird. Durch diese drei Maßnahmen ergeben sich folgende Vorteile, nämlich geringere Stromaufnahme bei vorgegebener oberer Grenzfrequenz, sowie höherer Strörabstand und geringeres Phasenrauschen.

In einer einfachen Weiterbildung kann der 4/5-Teiler zu einem umschaltbaren $2^n/2^{n+1}$-Teiler erweitert werden. Eine derartige Erweiterung zu einem 64/65 bzw. 128/129-Teiler ist in Figur 2 dargestellt. Mit 10, 11 sind wiederum die Ausgangsklemmen der in Figur 1 dargestellten 4/5-Teilers dargestellt, welche mit dem differentiellen Takteingang eines weiteren Flip-Flops 12 verbunden sind. Diesem Flip-Flop 12 können beliebig viele weitere Flip-Flops in Reihe nachgeschaltet werden, wobei jeweils der invertierte Ausgang $\overline{Q}_n$ mit dem jeweiligen Takteingang $C_n$ des nachgeschalteten Flip-Flops verbunden ist. Im in Figur 2 dargestellten Beispiel sind fünf Flip-Flops 12, 13, 14, 15, 16 auf diese Weise in Reihe geschaltet. Des weiteren ist jedem Flip-Flop ein ODER-Gatter zugeordnet. Der Ausgang $Q_{18}$ des ersten ODER-Gatters 18 ist mit den differentiellen Steueranschlüssen 6, 7 verbunden. Die nachfolgenden vier weiteren ODER-Gatter 19, 20, 21, 22 sind derart in Reihe geschaltet, daß jeweils der erste differentielle Eingang $A_{18}$, $A_{19}$, $A_{20}$, $A_{21}$ mit dem jeweiligen Ausgang $Q_{19}$, $Q_{20}$, $Q_{21}$, $Q_{22}$, des vorgeschalteten ODER-Gatters 19, 20, 21, 22 verbunden ist. Der jeweils zweite Eingang $B_{18}$, $B_{19}$, $B_{20}$, $B_{21}$ ist jeweils mit dem invertierten Ausgang $\overline{Q}_{12}...\overline{Q}_{15}$ des jeweils zugehörigen Flip-Flops 12..15 verbunden. Am ersten Eingang $A_{22}$ des ODER-Gatters 22 wird über die Eingangsklemmen 23, 24 das differentielle Steuersignal zum Umschalten des Teilermodus zugeführt. Des weiteren ist ein Multiplexer 17 vorgesehen, mit zwei differentiellen Eingängen $A_{17}$, $B_{17}$ und einem differentiellen invertierten Ausgang $\overline{Q}_{17}$. Mit 25, 26 sind Eingangsklemmen zum Zuführen eines differentiellen Steuersignals für den Multiplexer 17 bezeichnet. Der erste Eingang $A_{17}$ des Multiplexers 17 ist im dargestellten Beispiel mit dem Ausgang $Q_{15}$ des Flip-Flops 15 verbunden. Der zweite Eingang $B_{17}$ des Multiplexers 17 ist mit dem Ausgang $Q_{16}$ des Flip-Flops 16 verbunden. Am Ausgang $\overline{Q}_{17}$ ist das differentielle invertierte Ausgangssignal an den Klemmen 27, 28 abgreifbar und wird zudem dem zweiten Eingang $B_{22}$ des ODER-Gatters 22 zugeführt.

Das in Figur 2 dargestellte Ausführungsbeispiel zeigt einen 64/65 bzw. einen 128/129-Teiler. Durch Anlegen eines Steuersignals an den Klemmen 25, 26 kann entweder der 64/65-Modus oder der 128/129-Modus ausgewählt werden. Zwischen den jeweiligen zwei Teilermodi der jeweiligen Betriebsart kann durch Anlegen eines differentiellen Steuersignals an den Klemmen 23, 24 ausgewählt werden.

Andere Teilerverhältnisse können durch Weglassen eines Flip-Flops, ODER-Gatter-Kombination z.B. des Flip-Flops 12 und zugehörigen ODER-Gatters 18 bzw. durch Kaskadierung einer zusätzlichen Stufe realisiert werden. Ebenso können über einen Multiplexer ein beliebiges bzw. mehrere beliebige differentielle Ausgangssignale ausgewählt werden und dem eigentlichen Ausgang der Teilerschaltung zugeführt werden. So wären im dargestellten Beispiel gemäß Figur 1/2 die Ausgangssignale des Flip-Flops 5, 12, 13, 14, 15, 16 beliebig auswählbar, so daß zwischen einem 4/5, 8/9, 16/17, 32/33, 64/65 und 128/129-Teiler umgeschaltet werden könnte.

**Patentansprüche**

1. Schaltungsanordnung zum Teilen eines Taktsignals mit umschaltbaren Teilerverhältnissen 4/5 in ECL-Technik, mit drei in Reihe geschalteten Flip-Flops (2, 4), wobei der positive Ausgang ($Q_2$, $Q_4$) eines Flip-Flops (2, 4) jeweils mit dem Dateneingang ($D_4$, $D_5$) des nachfolgenden Flip-Flops (4, 5) gekoppelt ist und die Takteingänge ($C_2$; $C_4$; $C_5$) der Flip-Flops (2, 4, 5) mit dem Taktsignal (8, 9) beaufschlagt werden,
   **dadurch gekennzeichnet,** daß ein erstes UND-Gatter (3) vorgesehen ist, daß zwischen ersten und zweiten Flip-Flop (2, 4) geschaltet, wobei dessen Ausgang ($Q_3$) mit dem Dateneingang ($D_4$) des zweiten Flip-Flops (4) verbunden ist und dessen erster Eingang ($A_3$) mit dem invertierten Ausgang ($\overline{Q}_2$) eines dritten Flip-Flops (2) verbunden ist und dessen zweiter Eingang ($B_3$) mit dem invertierten Ausgangssignal ($\overline{Q}_5$) des ersten Flip-Flops (5) beaufschlagt wird und daß dem ersten Flip-Flop (2) ein UND-Gatter (1) vorgeschaltet ist, dessen erster Eingang ($A_1$) mit einem Steuersignal zur Umschaltung des Teilerverhältnisses und dessen zweiter Eingang ($B_1$) mit dem invertierten Ausgangssignal ($\overline{Q}_5$) des dritten Flip-Flops (5) beaufschlagt wird und wobei die gesamte Schaltungsanordnung in differentieller Technik ausgeführt ist.

2. Schaltungsanordnung nach Anspruch 1,
   **dadurch gekennzeichnet,** daß n Teilerstufen (n ≥ 1) vorgesehen sind, die jeweils aus einem Flip-Flop (12..16) und einer ODER-Stufe (18..22) bestehen, wobei die Flip-Flops (12..16) derart in Reihe zum Ausgang des dritten Flip-Flops (5) geschaltet sind, daß der jeweils invertierte Ausgang ($Q_5$, $Q_{12}..Q_{15}$) eines jeden Flip-Flops (5, 12..15) jeweils mit dem Takteingang ($C_{12}..C_{16}$)des nachfolgenden Flip-Flops (12..16) verbunden ist und wobei dem ersten Eingang ($A_1$) des UND-Gatters (1) die n in Reihe geschalteten ODER-Gatter (18..22) vorgeschaltet sind, wobei jeweils der erste Eingang ($A_{18}..A_{21}$) eines jeden ODER-Gatters (18..22) mit dem Ausgangssignal des jeweils vorgeschalteten ODER-Gatters (19..22) beaufschlagt wird und der zweite Eingang ($B_{18}..B_{21}$) mit dem jeweiligen invertierten Ausgangssignal des jeweils zugehörigen Flip-Flops (12..16) verbunden ist und der erste Eingang ($A_{22}$) des ersten ODER-Gatters (22) mit dem Steuersignal und der Ausgang ($R_{18}$) des letzten ODER-Gatters (18) mit dem ersten Eingang des UND-Gatters (1) verbunden ist.

3. Schaltungsanordnung nach Anspruch 2,
   **dadurch gekennzeichnet,** daß ein Multiplexer (17) vorgesehen ist, den wenigstens zwei Ausgangssignale zweier in Reihe geschalteter Flip-Flops (5, 12..16) zugeführt werden und an dessen Ausgang (27, 28) das geteilte Taktsignal abgreifbar ist.

FIG 1

FIG 2

| EINSCHLÄGIGE DOKUMENTE | | | EP 95106996.2 |
|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (Int. Cl.6) |
| A | DD - A - 229 846<br>(VEB MESSELEKTRONIK BERLIN)<br>* Gesamt *<br>-- | 1 | H 03 K 23/66 |
| A | US - A - 5 189 685<br>(JAFFARD et al.)<br>* Gesamt *<br>-- | 1 | |
| A | US - A - 4 545 063<br>(KAMIMARU)<br>* Zusammenfassung; Fig. *<br>-- | 1 | |
| A | PATENT ABSTRACTS OF JAPAN,<br>unexamined applications,<br>E field, Band 14, Nr. 9,<br>10. Jänner 1990<br>THE PATENT OFFICE JAPANESE<br>GOVERNMENT<br>Seite 125 E 870;<br>& JP-A-01 255 319 (NEC)<br>-- | 1 | RECHERCHIERTE SACHGEBIETE (Int. Cl.6) |
| A | US - A - 4 975 931<br>(COSAND)<br>* Zusammenfassung; Fig. *<br>---- | 1 | H 03 K 23/00<br>H 03 K 21/00 |

Der vorliegende Recherchenbericht wurde für alle Patentansprüche erstellt.

| Recherchenort | Abschlußdatum der Recherche | Prüfer |
|---|---|---|
| WIEN | 31-07-1995 | FELLNER |